# EUROPEAN PATENT APPLICATION

(11) **EP 4 848 945 A1**
(43) Date of publication of application: **02.12.2026**
(21) Application number: 24919549.6
(22) Date of filing: 16.04.2024
(51) Int. Cl.: H10F 10/14

(54) **PHOTOVOLTAIC CELL AND PHOTOVOLTAIC CELL MANUFACTURING METHOD**

(30) Priority: 22.01.2024 CN 202410087476
(71) Applicant: CHINT New Energy Technology Co., Ltd., Haining, Zhejiang 314400 (CN)
(72) Inventor: XU, Kun, Jiaxing, Zhejiang 314400 (CN); YU, Hao, Jiaxing, Zhejiang 314400 (CN); CAI, Yongmei, Jiaxing, Zhejiang 314400 (CN); HE, Sheng, Jiaxing, Zhejiang 314400 (CN); HSU, Wei-chih, Jiaxing, Zhejiang 314400 (CN)
(74) Representative: PGA S.p.A., Milano, Succursale di Lugano
(86) International application number: PCT/CN2024/087948
(87) International publication number: WO 2025/156459

(57) **Abstract**

A photovoltaic cell and a photovoltaic cell manufacturing method, which are applied in the field of photovoltaic cell manufacturing. A back surface of a substrate in the photovoltaic cell comprises a conductive region functional layer and a non-conductive region functional layer, wherein the conductive region functional layer comprises a first passivation layer arranged on the back surface of the substrate and a back metal gate line arranged on a back side of the substrate; the non-conductive region functional layer comprises a second passivation layer arranged on the back surface of the substrate; the first passivation layer at least comprises, from the back surface of the substrate to the outside, a first tunneling layer and a first polysilicon layer that are sequentially stacked; the total thickness of the polysilicon layer arranged in the first passivation layer is at least a first preset thickness; and a polysilicon layer is correspondingly provided in the second passivation layer, the total thickness of the polysilicon layer correspondingly arranged in the second passivation layer is a second preset thickness, and the second preset thickness is less than the first preset thickness, or no polysilicon layer is provided in the second passivation layer. By reducing the thickness of a polysilicon layer in a non-conductive region, the optical parasitic absorption of the polysilicon layer is reduced.

## Description

This application claims the priority of Chinese Patent Application No.202410087476.7, filed with the China National Intellectual Property Administration on January 22, 2024, and titled with "PHOTOVOLTAIC CELL AND PHOTOVOLTAIC CELL MANUFACTURING METHOD", the disclosure of which is hereby incorporated by its reference in entirety.

### FIELD

The present disclosure relates to the field of photovoltaic cell manufacture, particularly to a photovoltaic cell and a manufacturing method therefor.

### BACKGROUND

Taking TOPCon cells, a type of tunnel oxide passivated contact (TopCon) solar cell based on the principle of selective carrier transport. as an example, in current processes for manufacturing crystalline silicon-based TOPCon cells, the poly-Si (polycrystalline silicon) layer on the back side of the cell needs to be 120 nm thick to prevent the slurry in the conductive region from burning through the contact. However, since the poly-Si layer of the crystalline silicon-based TOPCon cell has a light-absorbing property, it can absorb long-wavelength light at the back side, which leads to a poor quantum efficiency response to long-wavelength light and a reduced short-circuit current and ultimately diminished photovoltaic cell performance.

### SUMMARY

In view of the above, a purpose of the present disclosure is to provide a photovoltaic cell and a method for manufacturing a photovoltaic cell, addressing the shortcomings of the prior art where long-wavelength light is absorbed by the back side poly-Si layer, leading to a poor back side quantum efficiency response to long-wavelength light and low short-circuit current of the cell.

To address the issues above, the present disclosure provides a photovoltaic cell, comprising
a substrate, a first functional layer disposed on a front side of the substrate and a second functional layer disposed on a back side of the substrate,
wherein the second functional layer comprises a conductive-region functional layer and a non-conductive-region functional layer; the conductive-region functional layer comprises a first passivation layer disposed on the back side of the substrate and a back-side metal grid line disposed on the back side of the substrate; and the non-conductive-region functional layer comprises a second passivation layer disposed on the back side of the substrate;
the first passivation layer at least comprises a first tunneling layer and a first polycrystalline silicon layer sequentially stacked in an outward direction away from the back side of the substrate, a total thickness of a polycrystalline silicon layer of the first passivation layer is at least a first preset thickness, and the polycrystalline silicon layer of the first preset thickness is to prevent a slurry of metal grid line from burning through the polycrystalline silicon layer;
correspondingly, the second passivation layer is provided with a polycrystalline silicon layer, wherein a total thickness of the polycrystalline silicon layer of the second passivation layer is a second preset thickness, and the second preset thickness is less than the first preset thickness; or the second passivation layer is not provided with a polycrystalline silicon layer, and
one end of the back-side metal grid line is provided in the first polycrystalline silicon layer, and the other end of the back-side metal grid line is exposed on the back side of the photovoltaic cell

Optionally, the first passivation layer comprises the first tunneling layer, the first polycrystalline silicon layer, a second tunneling layer and a second polycrystalline silicon layer sequentially stacked in an outward direction away from the back side of the substrate, a total thickness of the first polycrystalline silicon layer and the second polycrystalline silicon layer is at least the first preset thickness; and
correspondingly, the second passivation layer comprises a first tunneling layer and a first polycrystalline silicon layer, and a thickness of the first polycrystalline silicon layer is the second preset thickness.

Optionally, the first passivation layer comprises the first tunneling layer, the first polycrystalline silicon layer and a metal oxide passivation layer sequentially stacked in an outward direction away from the back side of the substrate, a thickness of the first polycrystalline silicon layer is at least the first preset thickness; and
correspondingly, the second passivation layer is a metal oxide passivation layer.

Optionally, both the first passivation layer and the second passivation layer are provided with a silicon nitride protective layer on the side facing away from the substrate.

Optionally, the first functional layer comprises a front-side passivation layer and a front-side metal grid line in an outward direction away from the front side of the substrate, and
correspondingly, the front-side passivation layer is a metal oxide passivation layer.

The present disclosure further provides a method for manufacturing the photovoltaic cell described above, comprising:
providing a photovoltaic cell preform, wherein the photovoltaic cell preform is at least provided with a first tunneling layer, a first polycrystalline silicon layer and a masking layer sequentially stacked in an outward direction away from a back side of a substrate, a total thickness of a polycrystalline silicon layer disposed on a back side of the photovoltaic cell preform is at least a first preset thickness, and the polycrystalline silicon layer of the first preset thickness is to prevent a slurry of metal grid line from burning through the polycrystalline silicon layer; dividing the back side of the photovoltaic cell preform into a conductive region and a non-conductive region, removing the masking layer in the non-conductive region by etching to obtain a first patterned photovoltaic cell preform,
at least removing a partial thickness of the polycrystalline silicon layer in the non-conductive region, and
providing a back-side metal grid line in the conductive region, wherein one end of the back-side metal grid line is provided in the first polycrystalline silicon layer, and the other end of the back-side metal grid line is exposed on the back side of the photovoltaic cell

Optionally, the photovoltaic cell preform is at least provided with the first tunneling layer, the first polycrystalline silicon layer, a second tunneling layer, a second polycrystalline silicon layer and the masking layer sequentially stacked in an outward direction away from the back side of the substrate, a total thickness of the first polycrystalline silicon layer and the second polycrystalline silicon layer is at least the first preset thickness, and a thickness of the first polycrystalline silicon layer is a second preset thickness, and
correspondingly, the at least removing a partial thickness of the polycrystalline silicon layer in the non-conductive region is carried out by:
at least removing the second polycrystalline silicon layer in the non-conductive region.

Optionally, the first polycrystalline silicon layer in the non-conductive region is removed, and a metal oxide passivation layer is provided on the back side of the substrate.

Optionally, the dividing the back side of the photovoltaic cell preform into a conductive region and a non-conductive region, and the removing the masking layer in the non-conductive region by etching to obtain a first patterned photovoltaic cell preform are carried out by:
providing a barrier slurry on a surface of the masking layer in the conductive region to prevent the masking layer in the conductive region from being etched, and
immersing the back side of the photovoltaic cell preform in an etchant to remove the masking layer in the non-conductive region.

Optionally, a boron silicate glass (BSG) masking layer is disposed on a front side of the substrate, and the BSG masking layer is configured to protect a structure on the front side of the photovoltaic cell preform from being etched when the photovoltaic cell preform is immersed in the etchant, wherein the BSG masking layer is retained from boron diffusion on the front side of the substrate.

Optionally, the masking layer is a phosphosilicate glass layer,
correspondingly, the immersing the back side of the photovoltaic cell preform in an etchant to remove the masking layer in the non-conductive region is carried out by:
immersing the back side of the photovoltaic cell preform in a hydrofluoric acid etchant to remove the phosphosilicate glass layer in the non-conductive region.

Optionally, the dividing the back side of the photovoltaic cell preform into a conductive region and a non-conductive region, and the removing the masking layer in the non-conductive region by etching to obtain a first patterned photovoltaic cell preform are carried out by:
dividing the back side of the photovoltaic cell preform into the conductive region and the non-conductive region, applying an etching slurry on a surface of the masking layer in the non-conductive region and removing the masking layer in the non-conductive region using the etching slurry to obtain the first patterned photovoltaic cell preform.

Optionally, the at least removing a partial thickness of the polycrystalline silicon layer in the non-conductive region is carried out by:
at least removing a partial thickness of the polycrystalline silicon layer in the non-conductive region using an alkaline solution and an additive.

In conclusion, the photovoltaic cell provided in the present disclosure comprises a substrate, a first functional layer disposed on the front side of the substrate, and a second functional layer disposed on the back side of the substrate. The second functional layer comprises a conductive-region functional layer and a non-conductive-region functional layer, the conductive-region functional layer comprises a first passivation layer disposed on the back side of the substrate and a back-side metal grid line disposed on the back side of the substrate, and the non-conductive-region functional layer comprises a second passivation layer disposed on the back side of the substrate. The first passivation layer at least comprises a first tunneling layer and a first polycrystalline silicon layer sequentially stacked in an outward direction away from the back side of the substrate, a total thickness of the polycrystalline silicon layer in the first passivation layer is at least a first preset thickness, and the polycrystalline silicon layer of the first preset thickness is to prevent a slurry of metal grid line from burning through the polycrystalline silicon layer. Correspondingly, the second passivation layer is provided with a polycrystalline silicon layer, wherein a total thickness of the polycrystalline silicon layer in the second passivation layer is a second preset thickness, and the second preset thickness is less than the first preset thickness; or the second passivation layer is not provided with a polycrystalline silicon layer. One end of the back-side metal grid line is provided in the first polycrystalline silicon layer, and the other end of the back-side metal grid line is exposed on the back side of the photovoltaic cell The present disclosure decreases the thickness of the polycrystalline silicon layer in non-conductive region to reduce its optical parasitic absorption, thereby enhancing the reflection of long-wavelength light, improving the quantum efficiency response to long-wavelength light, and ultimately increasing the short-circuit current of the photovoltaic cell.

Furthermore, the present disclosure further provides a method for manufacturing a photovoltaic cell, which similarly exhibits the aforementioned beneficial effects.

### BRIEF DESCRIPTION OF DRAWINGS

In order to describe the technical solutions in the embodiments of the present disclosure or in the prior art more clearly, the drawings for describing the embodiments or the prior art are briefly introduced hereinafter. Apparently, the drawings in the following description show merely the examples of the present disclosure, and those skilled in the art can obtain other drawings based on these drawings without making inventive efforts.
FIG. 1 is a structural schematic diagram of a photovoltaic cell provided in an example of the present disclosure.
FIG. 2 is a structural schematic diagram of another photovoltaic cell provided in an example of the present disclosure.
FIG. 3 is a flowchart for a method of manufacturing a photovoltaic cell provided in an example of the present disclosure.

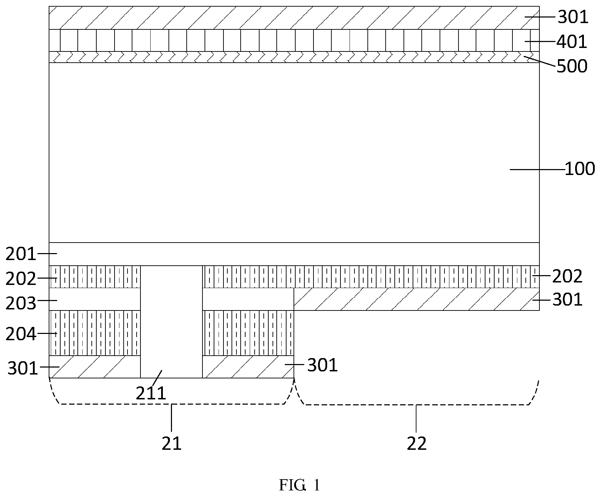

Reference numerals in FIGs. 1-2 are as follows:
100: substrate,
21; conductive-region functional layer, 22: non-conductive-region functional layer, 201: first tunneling layer, 202: first polycrystalline silicon layer, 203: second tunneling layer, 204: second polycrystalline silicon layer, 211: back-side metal grid line;
301: silicon nitride protective layer,
401: metal oxide passivation layer, and
500: textured surface.

### DETAILED DESCRIPTION

In order to make the purposes, technical solutions and advantages of the embodiments of the present disclosure clearer, the technical solutions in the embodiments of the present disclosure will be described clearly and completely hereinafter with reference to the drawings of the examples of the present disclosure. Apparently, the examples described below are some of the embodiments of the present disclosure, rather than all of the embodiments. Based on the examples of the present disclosure, all other examples obtained by those skilled in the art without making any inventive work fall into the protection scope of the present disclosure.

### Example 1

Referring to FIG. 1 (a structural schematic diagram of a photovoltaic cell provided in an example of the present disclosure), the photovoltaic cell may comprise:
a substrate 100, a first functional layer disposed on the front side of the substrate 100, and a second functional layer disposed on the back side of the substrate 100.

The second functional layer comprises a conductive-region functional layer 21 and a non-conductive-region functional layer 22, the conductive-region functional layer 21 comprises a first passivation layer disposed on the back side of the substrate 100 and a back-side metal grid line 211 disposed on the back side of the substrate 100, and the non-conductive-region functional layer 22 comprises a second passivation layer disposed on the back side of the substrate 100.

The first passivation layer at least comprises a first tunneling layer 201 and a first polycrystalline silicon layer 202 sequentially stacked in an outward direction away from the back side of the substrate 100, a total thickness of a polycrystalline silicon layer in the first passivation layer is at least a first preset thickness, and the polycrystalline silicon layer of the first preset thickness is to prevent a slurry of metal grid line from burning through the polycrystalline silicon layer.

Correspondingly, the second passivation layer is provided with a polycrystalline silicon layer, wherein a total thickness of the polycrystalline silicon layer in the second passivation layer is a second preset thickness, and the second preset thickness is less than the first preset thickness; or the second passivation layer is not provided with a polycrystalline silicon layer.

One end of the back-side metal grid line 211 is provided in the first polycrystalline silicon layer 202, and the other end of the back-side metal grid line 211 is exposed on the back side of the photovoltaic cell

The present disclosure primarily improves the photovoltaic cell having a Poly finger structure. The polycrystalline silicon layer is generally 120 nm thick solely to prevent the slurry under the finger from burning through the contact, while only a 20 nm thick polycrystalline silicon layer is required to meet passivation needs under the non-finger region. Such a cell structure, where a thick polycrystalline silicon layer is under the finger and a thin polycrystalline silicon layer is under a non-finger region, is called as Poly finger structure.

In this example, the substrate 100 may be either an N-type or a P-type substrate; no specific limitation is imposed. In this example, for the polycrystalline silicon layer in the first passivation layer in the conductive region, a thickness of the polycrystalline silicon layer in the first passivation layer is set to be greater than the thickness of the polycrystalline silicon layer burnt through by the slurry, so as to prevent the slurry from burning through the polycrystalline silicon layer during preparing the metal grid line, thereby protecting device from damage. In addition, the total thickness of the polycrystalline silicon layer in the second passivation layer is set to be a second preset thickness, or the second passivation layer is not provided with a polycrystalline silicon layer, so as to minimize the thickness of the polycrystalline silicon layer in the second passivation layer, thereby reducing the absorption of long-wavelength light by the polycrystalline silicon layer. It should be noted that when the back-side passivation layer in this example is formed solely by a tunneling layer and a polycrystalline silicon layer, the polycrystalline silicon layer in the second passivation layer may retain the second preset thickness. In the second passivation layer, the polycrystalline silicon layer having a second preset thickness is configured to ensure passivation in the non-conductive region functional layer. When other materials are used for the passivation layer, the thickness of the polycrystalline silicon layer can be reduced, or the polycrystalline silicon layer can even be omitted entirely. In this example, the first preset thickness is greater than the second preset thickness. Typically, the first preset thickness may be 120 nm, and the second preset thickness may be 20 nm. In this example, the position and manufacture method of the back-side metal grid line 211 may follow the existing techniques known in the art. In existing techniques, a textured surface 500 is generally provided on the front side of the substrate to improve photovoltaic conversion efficiency.

Furthermore, in structures of back-side passivation layer formed by a polycrystalline silicon layer and a tunneling layer, the use of polycrystalline silicon in the non-conductive region is reduced. The first passivation layer may comprise the first tunneling layer 201, the first polycrystalline silicon layer 202, a second tunneling layer 203 and a second polycrystalline silicon layer 204 sequentially stacked in an outward direction away from the back side of the substrate 100, and a total thickness of the first polycrystalline silicon layer 202 and the second polycrystalline silicon layer 204 is at least the first preset thickness.

Correspondingly, the second passivation layer comprises the first tunneling layer 201 and the first polycrystalline silicon layer 202, and a thickness of the first polycrystalline silicon layer 202 is the second preset thickness.

In this example, the first passivation layer employs a stacked structure formed by the first tunneling layer 201, the first polycrystalline silicon layer 202, the second tunneling layer 203 and the second polycrystalline silicon layer 204, the second passivation layer employs a stacked structure formed by the first tunneling layer 201 and the first polycrystalline silicon layer 202, the first polycrystalline silicon layer 202 has the second preset thickness, and the total thickness of the second polycrystalline silicon layer 204 and the first polycrystalline silicon layer 202 is the first preset thickness. While fulfilling the functional requirements of the polycrystalline silicon layer, these structures enable simultaneous manufacture of the first tunneling layer 201 and the first polycrystalline silicon layer 202 in both conductive and non-conductive regions, thereby enhancing manufacture efficiency.

Furthermore, in order to protect the back side of the device and prevent the first passivation layer and the second passivation layer from being etched and damaged, both the first passivation layer and the second passivation layer can be provided with a silicon nitride protective layer 301 on the side facing away from the substrate 100.

In this example, the silicon nitride protective layer 301 disposed on the outer side of both the first passivation layer and the second passivation layer can protect the first passivation layer and the second passivation layer, thereby enhancing the stability of the device.

Furthermore, to ensure normal device operation, the first functional layer may be provided with a front-side passivation layer and front-side metal grid line in an outward direction away from the front side of the substrate 100.

The front-side passivation layer corresponds to a metal oxide passivation layer 401.

In this example, the front-side passivation layer is the metal oxide passivation layer 401, and the front-side metal grid line is disposed on the front side, which together enable stable operation of the photovoltaic cell device. It should be further noted that a front-side textured surface may also be disposed on the surface of the front side of the substrate 100 to improve photovoltaic conversion efficiency. The example does not limit the specific material of the metal oxide passivation layer 401 disposed on the front side, and it may be selected according to process requirements and performance considerations. For example, aluminum oxide may be used to form the front-side passivation layer.

The photovoltaic cell provided in the example of the present disclosure comprises the substrate 100, the first functional layer disposed on the front side of the substrate 100 and the second functional layer disposed on the back side of the substrate 100. The second functional layer comprises a conductive-region functional layer 21 and a non-conductive-region functional layer 22, the conductive-region functional layer 21 comprises a first passivation layer disposed on the back side of the substrate 100 and a back-side metal grid line 211 disposed on the back side of the substrate 100, and the non-conductive-region functional layer 22 comprises a second passivation layer disposed on the back side of the substrate 100. The first passivation layer at least comprises a first tunneling layer 201 and a first polycrystalline silicon layer 202 sequentially stacked in an outward direction away from the back side of the substrate 100, a total thickness of a polycrystalline silicon layer in the first passivation layer is at least a first preset thickness, and the polycrystalline silicon layer of the first preset thickness is to prevent a slurry of metal grid line from burning through the polycrystalline silicon layer. Correspondingly, the second passivation layer is provided with a polycrystalline silicon layer, wherein a total thickness of the polycrystalline silicon layer in the second passivation layer is a second preset thickness, and the second preset thickness is less than the first preset thickness; or the second passivation layer is not provided with a polycrystalline silicon layer. One end of the back-side metal grid line 211 is provided in the first polycrystalline silicon layer 202, and the other end of the back-side metal grid line 211 is exposed on the back side of the photovoltaic cell. The present disclosure decreases the thickness of the polycrystalline silicon layer in non-conductive region to reduce its optical parasitic absorption, thereby enhancing the reflection of long-wavelength light, improving the quantum efficiency response to long-wavelength light, and ultimately increasing the short-circuit current of the photovoltaic cell. In addition, in the example of the present disclosure, the first passivation layer employs a stacked structure formed by the first tunneling layer 201, the first polycrystalline silicon layer 202, the second tunneling layer 203 and the second polycrystalline silicon layer 204, the second passivation layer employs a stacked structure formed by the first tunneling layer 201 and the first polycrystalline silicon layer 202, the first polycrystalline silicon layer 202 has the second preset thickness, and the total thickness of the second polycrystalline silicon layer 204 and the first polycrystalline silicon layer 202 is the first preset thickness, enhancing the manufacture efficiency. The silicon nitride protective layer 301 disposed on the outer side of both the first passivation layer and the second passivation layer can protect the first passivation layer and the second passivation layer, thereby enhancing the stability of the device. The front-side passivation layer is the metal oxide passivation layer 401, and the front-side metal grid line is disposed on the front side, which together enable stable operation of the photovoltaic cell device.

### Example 2

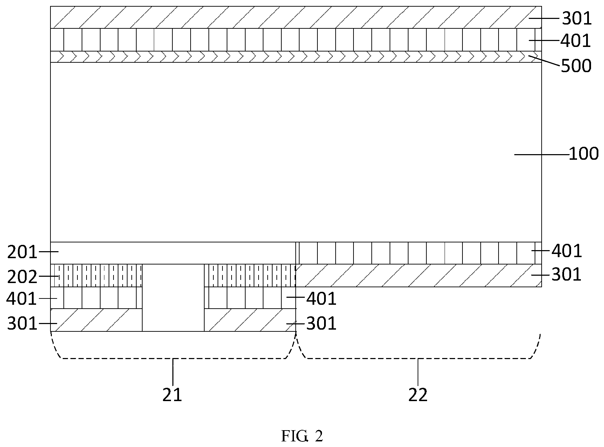

Referring to FIG 2 (a structural schematic diagram of another photovoltaic cell provided in an example of the present disclosure), the photovoltaic cell may comprise:
a substrate 100, a first functional layer disposed on the front side of the substrate 100, and a second functional layer disposed on the back side of the substrate 100.

The second functional layer comprises a conductive-region functional layer 21 and a non-conductive-region functional layer 22, the conductive-region functional layer 21 comprises a first passivation layer disposed on the back side of the substrate 100 and a back-side metal grid line 211 disposed on the back side of the substrate 100, and the non-conductive-region functional layer 22 comprises a second passivation layer disposed on the back side of the substrate 100.

The first passivation layer comprises a first tunneling layer 201, a first polycrystalline silicon layer 202 and a metal oxide passivation layer 401 sequentially stacked in an outward direction away from the back side of the substrate 100, and the thickness of the first polycrystalline silicon layer 202 is at least a first preset thickness.

The second passivation layer corresponds to the metal oxide passivation layer 401.

One end of the back-side metal grid line 211 is provided in the first polycrystalline silicon layer 202, and the other end of the back-side metal grid line 211 is exposed on the back side of the photovoltaic cell

It should be noted that, in the example, the second passivation layer is the metal oxide passivation layer 401, eliminating the need for polycrystalline silicon in the non-conductive region. This approach minimizes absorption of long-wavelength light by the non-conductive region, thus improving the photovoltaic conversion efficiency. It should be noted that the total thickness of the polycrystalline silicon layer disposed in the conductive region should be the first preset thickness, so as to prevent the polycrystalline silicon layer from being burned through by the back-side metal grid line 211 during the preparation. This example does not limit the specific material of the metal oxide passivation layer 401, provided that it meets the requirement of passivation on the back side of the substrate 100. For example, the metal oxide passivation layer 401 may be made using aluminum oxide. The thickness of the aluminum oxide passivation layer may be adjusted according to device parameters.

The photovoltaic cell provided in the example of the present disclosure comprises the substrate 100, the first functional layer disposed on the front side of the substrate 100 and the second functional layer disposed on the back side of the substrate 100. The second functional layer comprises a conductive-region functional layer 21 and a non-conductive-region functional layer 22, the conductive-region functional layer 21 comprises a first passivation layer disposed on the back side of the substrate 100 and a back-side metal grid line 211 disposed on the back side of the substrate 100, and the non-conductive-region functional layer 22 comprises a second passivation layer disposed on the back side of the substrate 100. The first passivation layer comprises a first tunneling layer 201, a first polycrystalline silicon layer 202 and a metal oxide passivation layer 401 sequentially stacked in an outward direction away from the back side of the substrate 100, and the thickness of the first polycrystalline silicon layer 202 is at least a first preset thickness. Correspondingly, the second passivation layer is the metal oxide passivation layer 401. One end of the back-side metal grid line 211 is provided in the first polycrystalline silicon layer 202, and the other end of the back-side metal grid line 211 is exposed on the back side of the photovoltaic cell. The present disclosure decreases the thickness of the polycrystalline silicon layer in non-conductive region to reduce its optical parasitic absorption, thereby enhancing the reflection of long-wavelength light, improving the quantum efficiency response to long-wavelength light, and ultimately increasing the short-circuit current of the photovoltaic cell. The second passivation layer is set to be the metal oxide passivation layer 401, so as to eliminate the use of polycrystalline silicon in the non-conductive region, which further minimizes absorption of long-wavelength light by the non-conductive region, thus improving the photovoltaic conversion efficiency.

In the example of the present disclosure, the non-conductive region may be a non-metal grid line region in practical implementations. Furthermore, since the polycrystalline silicon layer of the present disclosure is doped, partially residual doped polycrystalline silicon layer in the non-conductive region would impart at least partial electrical conductivity to the non-conductive region.

A method of manufacturing the photovoltaic cell provided in an example of the present disclosure is described below. The method of manufacturing the photovoltaic cell described below and the photovoltaic cell described above may be referred to each other.

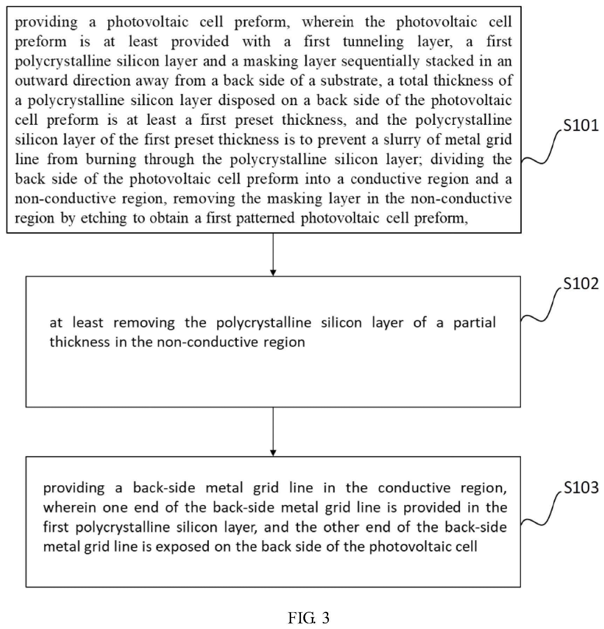

Specifically, referring to FIG 3 (a flowchart for a method of manufacturing a photovoltaic cell provided in an example of the present disclosure), the method may comprise the following steps.

S101: providing a photovoltaic cell preform, wherein the photovoltaic cell preform is at least provided with a first tunneling layer, a first polycrystalline silicon layer and a masking layer sequentially stacked in an outward direction away from the back side of the substrate, a total thickness of a polycrystalline silicon layer disposed on a back side of the photovoltaic cell preform is at least a first preset thickness, and the polycrystalline silicon layer of the first preset thickness is to prevent a slurry of metal grid line from burning through the polycrystalline silicon layer; dividing the back side of the photovoltaic cell preform into a conductive region and a non-conductive region, removing the masking layer in the non-conductive region by etching to obtain a first patterned photovoltaic cell preform.

In this example, the executing entity was a photovoltaic cell manufacture apparatus. The example provided a photovoltaic cell preform, which at least comprised a back-side passivation layer formed by the first tunneling layer and the first polycrystalline silicon layer stacked in an outward direction away from the back side of the substrate. The surface of the back-side passivation layer facing away from the substrate was divided into the conductive and non-conductive regions. The masking layer in the conductive region was retained to obtain the first patterned photovoltaic cell preform.

S102: at least removing a partial thickness of the polycrystalline silicon layer in the non-conductive region.

In this example, after the first patterned photovoltaic cell preform described above was obtained, a masking layer was used to protect the conductive region from being etched, and thus structures in the non-conductive region can be directly removed by etching. This example primarily removed the polycrystalline silicon layer in the non-conductive region. A partial thickness of the polycrystalline silicon layer in the non-conductive region was removed, leaving a remaining polycrystalline silicon layer with a second preset thickness in the non-conductive region, so as to maintain passivation effect and reduce the light absorption of the polycrystalline silicon layer. It should be noted that, in this example, when the non-conductive region employs a passivation layer formed by a tunneling layer and a polycrystalline silicon layer, a residual polycrystalline silicon layer of the second preset thickness must be retained to ensure the passivation capability of the non-conductive region. When the passivation layer in the non-conductive region is made from other materials, the polycrystalline silicon layer in this non-conductive region can be progressively thinned and may even be completely removed.

Furthermore, to ensure that the polycrystalline silicon in the non-conductive region is successfully etched, the at least removing a partial thickness of the polycrystalline silicon layer in the non-conductive region described above may be carried out by:
at least removing a partial thickness of the polycrystalline silicon layer in the non-conductive region using an alkaline solution and an additive.

In this example, an alkaline solution combined with the additive was used to etch the polycrystalline silicon layer in the non-conductive region, ensuring the successful etching.

S103: providing a back-side metal grid line in the conductive region, wherein one end of the back-side metal grid line is provided in the first polycrystalline silicon layer, and the other end of the back-side metal grid line is exposed on the back side of the photovoltaic cell

In this example, the step of providing the back-side metal grid line in the conductive region may be carried out referring to manufacture methods known in the art. In this example, a silicon nitride protective layer may be subsequently provided on the outer side of the back-side passivation layer, and an aluminum oxide layer, a silicon nitride protective layer and a front-side metal grid line may be sequentially provided on its front side. The manufacture methods may follow existing processes and are therefore not described herein in further detail.

Further, to improve the convenience of manufacture, the photovoltaic cell preform described above may be provided with at least a first tunneling layer, a first polycrystalline silicon layer, a second tunneling layer, a second polycrystalline silicon layer and a masking layer sequentially stacked in an outward direction away from the back side of the substrate. The total thickness of the first polycrystalline silicon layer and the second polycrystalline silicon layer is at least a first preset thickness, and the thickness of the first polycrystalline silicon layer is a second preset thickness.

Correspondingly, the at least removing a partial thickness of the polycrystalline silicon layer in the non-conductive region described above may be carried out by:
at least removing the second polycrystalline silicon layer in the non-conductive region.

It should be noted that, in this example, a first tunneling layer, a first polycrystalline silicon layer, a second tunneling layer, a second polycrystalline silicon layer and a masking layer were sequentially stacked in an outward direction away from the back side of the substrate. Correspondingly, in this example, after the masking layer in the non-conductive region was removed, the second polycrystalline silicon layer in the non-conductive region was directly removed, thereby removing extra polycrystalline silicon layer in the non-conductive region and ensuring the manufacture efficiency. Wherein, the second tunneling layer serves as a separation layer between the first polycrystalline silicon layer and the second polycrystalline silicon layer, which allows the removal of the second polycrystalline silicon layer without requiring precise control over the thickness of the removed polycrystalline silicon layer, thereby simplifying the removal process. Furthermore, it should be noted that, in this example, the second tunneling layer in the non-conductive region may either be removed together or retained in the non-conductive region. When only the second polycrystalline silicon layer in the non-conductive region is removed, the polycrystalline silicon layer with a second preset thickness in the non-conductive region is retained to ensure the passivation capability of the passivation layer in the non-conductive region.

Furthermore, to minimize the absorption of long-wavelength light by the polycrystalline silicon layer in the non-conductive region, the first polycrystalline silicon layer in the non-conductive region can be completely removed, and a metal oxide passivation layer can be disposed on the back side of the substrate.

In this example, the complete removal of the first polycrystalline silicon layer in the non-conductive region can minimize absorption of long-wavelength light by the back side of the photovoltaic cell, thereby enhancing photoelectric conversion efficiency while maintaining passivation on the back side of the substrate. It should be noted that, in this example, the first tunneling layer in the non-conductive region may either be removed or retained. In this example, the first tunneling layer in the non-conductive region was removed, all structures disposed on the outer side of the first tunneling layer in the non-conductive region were also removed. In such a case, the photovoltaic cell preform may be provided with a first tunneling layer, a first polycrystalline silicon layer and a masking layer sequentially stacked in an outward direction away from the back side of the substrate, and the thickness of the first polycrystalline silicon layer is at least a first preset thickness to ensure the convenience of manufacture. In addition, in this example, after the tunneling layer in the non-conductive region was completely removed, a metal oxide passivation layer may be directly provided on the back side of the substrate. It should be further noted that, when only the first polycrystalline silicon layer in the non-conductive region is removed and the first tunneling layer in the non-conductive region is retained, the metal oxide passivation layer is provided on the back side of the first tunneling layer. Moreover, in this example, the metal oxide passivation layer may also be simultaneously provided on the back side of the structures in the conductive region.

Furthermore, to ensure the efficiency of removing the masking layer in the non-conductive region, the step of dividing the back side of the photovoltaic cell preform into a conductive region and a non-conductive region and removing the masking layer in the non-conductive region by etching to obtain the first patterned photovoltaic cell preform may be carried out by the following steps:
step S11: providing a barrier slurry on the surface of the masking layer in the conductive region to prevent the masking layer in the conductive region from being etched, and
step S12: immersing the back side of the photovoltaic cell preform in an etchant to remove the masking layer in the non-conductive region.

In this example, a barrier slurry was provided on the surface of the masking layer in the conductive region, and then the back side of the photovoltaic cell preform was immersed in an etchant, which not only ensures the manufacture of a first patterned photovoltaic cell preform but also enhances the efficiency of removing the masking layer in non-conductive region by etching.

Furthermore, to ensure successful manufacture of the photovoltaic cell, a BSG masking layer may be provided on the front side of the substrate. During immersing the photovoltaic cell preform in the etchant, the BSG masking layer can protect the front-side structures of the photovoltaic cell preform from being etched. The BSG masking layer is retained from boron diffusion on the front side of the substrate.

In this example, the BSG masking layer retained from boron diffusion on the front side of the substrate, was used to protect the front-side structures of the photovoltaic cell preform from being etched when the photovoltaic cell preform was immersed in the etchant, ensuring the successful manufacture of the photovoltaic module and making the process convenient.

Furthermore, to ensure the removal of the masking layer in the non-conductive region by the etchant, the masking layer may be a phosphosilicate glass layer.

Correspondingly, the step of immersing the back side of the photovoltaic cell preform in the etchant to remove the masking layer in the non-conductive region may be carried out by:
immersing the back side of the photovoltaic cell preform in a hydrofluoric acid etchant to remove the phosphosilicate glass layer in the non-conductive region.

In this example, the masking layer was a phosphosilicate glass layer, and the hydrofluoric acid etchant was used to etch the phosphosilicate glass layer in the non-conductive region, thereby ensuring the successful manufacture of the first patterned photovoltaic cell preform.

Furthermore, to reduce the complexity of etching the masking layer in the non-conductive region, the step of dividing the back side of the photovoltaic cell preform into a conductive region and a non-conductive region and removing the masking layer in the non-conductive region by etching to obtain the first patterned photovoltaic cell preform may be alternatively carried out by:
dividing the back side of the photovoltaic cell preform into a conductive region and a non-conductive region and providing an etching slurry on the surface of the masking layer in the non-conductive region to remove the masking layer in the non-conductive region using the etching slurry and obtain the first patterned photovoltaic cell preform.

In this example, by directly providing an etching slurry on the surface of the masking layer in the non-conductive region, the masking layer in the non-conductive region can be directly etched by the etching slurry without subsequently immersing the back side of the photovoltaic cell preform in an etchant, thereby simplifying the process of etching the masking layer.

The method of manufacturing a photovoltaic cell provided in the example of the present disclosure comprises providing a photovoltaic cell preform, wherein the photovoltaic cell preform is at least provided with a first tunneling layer, a first polycrystalline silicon layer and a masking layer sequentially stacked in an outward direction away from the substrate, a total thickness of a polycrystalline silicon layer disposed on a back side of the photovoltaic cell preform is at least a first preset thickness, and the first preset thickness of the polycrystalline silicon layer is to prevent a metal grid line from burning through the polycrystalline silicon layer; dividing the back side of the photovoltaic cell preform into a conductive region and a non-conductive region, removing the masking layer in the non-conductive region by etching to obtain a first patterned photovoltaic cell preform, at least removing a partial thickness of the polycrystalline silicon layer in the non-conductive region, and providing a back-side metal grid line in the conductive region, wherein one end of the back-side metal grid line is provided in the first polycrystalline silicon layer, and the other end of the back-side metal grid line is exposed on the back side of the photovoltaic cell The present disclosure decreases the thickness of the polycrystalline silicon layer in non-conductive region to reduce its optical parasitic absorption, thereby enhancing the reflection of long-wavelength light, improving the quantum efficiency response to long-wavelength light, and ultimately increasing the short-circuit current of the photovoltaic cell. Moreover, in this example of the present disclosure, an alkaline solution combined with the additive was used to etch the polycrystalline silicon layer in the non-conductive region, ensuring the successful etching. A first tunneling layer, a first polycrystalline silicon layer, a second tunneling layer, a second polycrystalline silicon layer and a masking layer were sequentially stacked in an outward direction away from the back side of the substrate. Correspondingly, in this example, after the masking layer in the non-conductive region was removed, the second polycrystalline silicon layer in the non-conductive region was directly removed, thereby removing extra polycrystalline silicon layer in the non-conductive region and ensuring the manufacture efficiency. The complete removal of the first polycrystalline silicon layer in the non-conductive region can minimize absorption of long-wavelength light by the back side of the photovoltaic cell, thereby enhancing photoelectric conversion efficiency while maintaining passivation on the back side of the substrate. A barrier slurry was provided on the surface of the masking layer in the conductive region, and then the back side of the photovoltaic cell preform was immersed in an etchant, which not only ensures the manufacture of a first patterned photovoltaic cell preform but also enhances the efficiency of removing the masking layer in non-conductive region by etching. The BSG masking layer retained from boron diffusion on the front side of the substrate, was used to protect the front-side structures of the photovoltaic cell preform from being etched, ensuring the successful manufacture of the photovoltaic module and making the manufacture convenient. The masking layer was a phosphosilicate glass layer, and the hydrofluoric acid etchant was used to etch the phosphosilicate glass layer in the non-conductive region, thereby ensuring the successful manufacture of the first patterned photovoltaic cell preform. By directly providing an etching slurry on the surface of the masking layer in the non-conductive region, the masking layer in the non-conductive region can be directly etched away by the etching slurry without subsequently immersing the back side of the photovoltaic cell preform in an etchant, thereby simplifying the process of etching the masking layer.

To facilitate understanding of the present disclosure, the method of manufacturing a photovoltaic cell described above specifically comprises the following steps.

Step S1: An N-type silicon substrate is textured on both sides using an alkaline solution at a concentration of 2% (expressed as the volume percentage of the alkaline solution relative to the total bath volume), an additive A at a concentration of 1%, at a temperature of 82°C for a duration of 420 seconds. The additive A is a common texturing additive in the market. The textured silicon substrate is subjected to boron diffusion on one side to form a P⁺ emitter on the front side of the N-type substrate. The BSG layers are formed on both sides of the N-type substrate. The back side of the N-type substrate is exposed to hydrofluoric acid to remove the BSG layer on the back side of the N-type substrate remained after boron diffusion using a chain type BSG removal equipment. A first N-type substrate structure is obtained.

Step S2: The BSG layer on the front side serves as a masking layer for protection, and the back side of the first N-type substrate structure is subjected to alkaline etching using a batch-type alkaline polishing equipment with an alkaline polishing agent at a concentration of 4%, and an additive B at a concentration of 0.7%, at a temperature of 65°C for a duration of 160 seconds, to form a back-side alkaline-polished surface morphology. The additive B is a common alkaline polishing additive in the market. A second N-type substrate structure is obtained.

Step S3: At least a first tunneling layer and a first polycrystalline silicon layer are provided on the back side of the second N-type substrate structure. The multiple tunneling layers and polycrystalline silicon layers can be provided on the back side of the N-type substrate by an LPCVD dual insert stacking poly process (wherein the stacking poly refers to two or more tunneling layers and Poly-Si). A phosphosilicate glass (PSG) layer is also provided on the outermost surface and a third N-type substrate structure is obtained.

Step S4: In an outward direction away from the back side of the third N-type substrate structure, at least one tunneling layer, at least one polycrystalline silicon layer, and a PSG layer are stacked in sequence. In an inward direction toward the front side of the third N-type substrate structure, a PSG layer, at least one polycrystalline silicon wrap-around layer, at least one tunneling layer, a BSG layer, and a textured front surface are stacked. The outermost PSG layer on the front side is removed and a fourth N-type substrate structure is obtained.

Step S5: The polycrystalline silicon wrap-around layer and the tunneling layer on the front side of the fourth N-type substrate structure are removed, and then residual phosphorus at the edges of the N-type substrate structure is removed by alkaline etching. A fifth N-type substrate structure is obtained.

Step S6: On the back side of the fifth N-type substrate structure, the conductive and non-conductive regions are printed by using a screen printing machine equipped with a screen mask to form the patterned back surface. The printed grid lines are dried and cured in an oven, and a sixth N-type substrate structure is obtained.

Step S7: The sixth N-type substrate structure is subjected to the post-treatment using a chain type cleaner including a hydrofluoric acid immersion bath, an alkaline+BDG (butyl diglycol) bath, a high-pressure water rinse bath, a water spray cleaning bath, an alkaline+ hydrogen peroxide post-cleaning bath and a drying bath. In the hydrofluoric acid immersion bath, the PSG in the conductive region is protected by a printed hydrofluoric acid-resistant barrier slurry and thus not etched by hydrofluoric acid, and the PSG in the non-conductive region with no printed barrier slurry is completely etched away by hydrofluoric acid. The alkaline bath is used to remove the barrier slurry, the water bath and drying bath are used for cleaning and drying, and a seventh N-type substrate structure is obtained.

Step S8: By using a batch-type RCA cleaning system, at least a partial thickness of the polycrystalline silicon layer in the non-conductive region of the seventh N-type substrate structure is removed using an alkaline solution and additive, and the remaining polycrystalline silicon layer in the non-conductive region is at most of a second preset thickness. The RCA cleaning process is performed in an ozone-containing aqueous solution for 8 min, and then an eighth N-type substrate structure is obtained.

Step S9: An aluminum oxide thin film is grown on the front side of the eighth N-type substrate structure, and a silicon nitride thin film is grown on both the front side and back side of the eighth N-type substrate structure. The aluminum oxide thin film has a thickness of 6 nm, and the silicon nitride thin film has a thickness of 78 nm. The front-side and back-side metal grid lines are prepared on the front and back sides of the N-type substrate structure by screen printing, respectively, thereby completing the manufacture of the photovoltaic cell. It should be noted that when the polycrystalline silicon layer in the back-side non-conductive region is completely removed, an aluminum oxide layer may also be provided on the back side as a passivation layer.

The examples in the description are described in a progressive manner. Each of the examples is mainly focused on describing its differences from other examples, and the same and similar parts among the examples may be referred to each other. Since the devices disclosed in the examples correspond to the method disclosed in the examples, the description for the devices is simple, and reference may be made to the description of method for the relevant parts.

Those skilled in the art may further realize that the units and algorithm steps of each example described in the embodiments disclosed herein can be implemented by electronic hardware, computer software, or a combination of both. In order to clearly illustrate the interchangeability of hardware and software, the composition and steps of each example are described according to functionality in general terms in the above description. Whether a function is to be implemented by hardware or software depends on a particular application of the technical solutions and a design constraint. Those skilled in the art may use different methods to implement the described functions for each specific application, and such implementation should not be regarded as going beyond the scope of the present disclosure.

Finally, it should be further noted that in the present disclosure, the relationship terminologies such as "first" and "second" are only used to distinguish one entity or operation from another entity or operation, rather than to necessitate or imply an actual relationship or order between the entities or operations. Moreover, terms of "include", "comprise" or any other variants are intended to be non-exclusive. Therefore, a process, method, article or device including a series of elements includes not only the elements but also other elements that are not enumerated, or further includes elements inherent to the process, method, article or device.

A photovoltaic cell and a method for manufacturing a photovoltaic cell provided in the present disclosure are described above in detail. Although the principles and implementations of the present disclosure are described by using specific examples in the present disclosure, the descriptions of the foregoing examples are merely intended to help understand the method and the core concept of the method of the present disclosure. In addition, those skilled in the art may make modifications to the specific implementations and application range according to the concept of the present disclosure. In conclusion, the content of this specification is not to be construed as a limitation on the present disclosure.

## Claims

1. A photovoltaic cell, comprising:
a substrate, a first functional layer disposed on a front side of the substrate and a second functional layer disposed on a back side of the substrate,
wherein the second functional layer comprises a conductive-region functional layer and a non-conductive-region functional layer; the conductive-region functional layer comprises a first passivation layer disposed on the back side of the substrate and a back-side metal grid line disposed on the back side of the substrate; and the non-conductive-region functional layer comprises a second passivation layer disposed on the back side of the substrate;
the first passivation layer at least comprises a first tunneling layer and a first polycrystalline silicon layer sequentially stacked in an outward direction away from the back side of the substrate, a total thickness of the polycrystalline silicon layer in the first passivation layer is at least a first preset thickness, and the polycrystalline silicon layer of the first preset thickness is to prevent a slurry of metal grid line from burning through the polycrystalline silicon layer;
correspondingly, the second passivation layer is provided with a polycrystalline silicon layer, wherein a total thickness of the polycrystalline silicon layer in the second passivation layer is a second preset thickness, and the second preset thickness is less than the first preset thickness; or the second passivation layer is not provided with a polycrystalline silicon layer, and
one end of the back-side metal grid line is provided in the first polycrystalline silicon layer, and the other end of the back-side metal grid line is exposed on the back side of the photovoltaic cell.

2. The photovoltaic cell according to claim 1, wherein the first passivation layer comprises the first tunneling layer, the first polycrystalline silicon layer, a second tunneling layer and a second polycrystalline silicon layer sequentially stacked in an outward direction away from the back side of the substrate, a total thickness of the first polycrystalline silicon layer and the second polycrystalline silicon layer is at least the first preset thickness; and
correspondingly, the second passivation layer comprises a first tunneling layer and a first polycrystalline silicon layer, and a thickness of the first polycrystalline silicon layer is the second preset thickness.

3. The photovoltaic cell according to claim 1, wherein the first passivation layer comprises the first tunneling layer, the first polycrystalline silicon layer and a metal oxide passivation layer sequentially stacked in an outward direction away from the back side of the substrate, a thickness of the first polycrystalline silicon layer is at least the first preset thickness; and
correspondingly, the second passivation layer is a metal oxide passivation layer.

4. The photovoltaic cell according to claim 1, wherein both the first passivation layer and the second passivation layer are provided with a silicon nitride protective layer on a side facing away from the substrate.

5. The photovoltaic cell according to claim 3, wherein the first functional layer comprises a front-side passivation layer and a front-side metal grid line in an outward direction away from the front side of the substrate, and
correspondingly, the front-side passivation layer is a metal oxide passivation layer.

6. A method for manufacturing the photovoltaic cell according to any one of claims 1 to 5, comprising:
providing a photovoltaic cell preform, wherein the photovoltaic cell preform is at least provided with a first tunneling layer, a first polycrystalline silicon layer and a masking layer sequentially stacked in an outward direction away from a back side of a substrate, a total thickness of a polycrystalline silicon layer disposed on a back side of the photovoltaic cell preform is at least a first preset thickness, and the polycrystalline silicon layer of the first preset thickness is to prevent a slurry of metal grid line from burning through the polycrystalline silicon layer; dividing the back side of the photovoltaic cell preform into a conductive region and a non-conductive region, and removing the masking layer in the non-conductive region by etching to obtain a first patterned photovoltaic cell preform,
at least removing a partial thickness of the polycrystalline silicon layer in the non-conductive region, and
providing a back-side metal grid line in the conductive region, wherein one end of the back-side metal grid line is provided in the first polycrystalline silicon layer, and the other end of the back-side metal grid line is exposed on the back side of the photovoltaic cell

7. The method according to claim 6, wherein the photovoltaic cell preform is at least provided with the first tunneling layer, the first polycrystalline silicon layer, a second tunneling layer, a second polycrystalline silicon layer and the masking layer sequentially stacked in an outward direction away from the back side of the substrate, a total thickness of the first polycrystalline silicon layer and the second polycrystalline silicon layer is at least the first preset thickness, and a thickness of the first polycrystalline silicon layer is a second preset thickness, and
correspondingly, the at least removing a partial thickness of the polycrystalline silicon layer in the non-conductive region is carried out by at least removing the second polycrystalline silicon layer in the non-conductive region.

8. The method according to claim 6, wherein the first polycrystalline silicon layer in the non-conductive region is removed, and a metal oxide passivation layer is provided on the back side of the substrate.

9. The method according to claim 6, wherein the dividing the back side of the photovoltaic cell preform into a conductive region and a non-conductive region, and the removing the masking layer in the non-conductive region by etching to obtain a first patterned photovoltaic cell preform are carried out by:
providing a barrier slurry on a surface of the masking layer in the conductive region to prevent the masking layer in the conductive region from being etched, and
immersing the back side of the photovoltaic cell preform in an etchant to remove the masking layer in the non-conductive region.

10. The method according to claim 9, wherein a boron silicate glass (BSG) masking layer is disposed on a front side of the substrate, and the BSG masking layer is configured to protect a structure on the front side of the photovoltaic cell preform from being etched when the photovoltaic cell preform is immersed in the etchant, wherein the BSG masking layer is retained from boron diffusion on the front side of the substrate.

11. The method according to claim 9, wherein the masking layer is a phosphosilicate glass layer,
correspondingly, the immersing the back side of the photovoltaic cell preform in an etchant to remove the masking layer in the non-conductive region is carried out by:
immersing the back side of the photovoltaic cell preform in a hydrofluoric acid etchant to remove the phosphosilicate glass layer in the non-conductive region.

12. The method according to claim 6, wherein the dividing the back side of the photovoltaic cell preform into a conductive region and a non-conductive region, and the removing the masking layer in the non-conductive region by etching to obtain a first patterned photovoltaic cell preform are carried out by:
dividing the back side of the photovoltaic cell preform into the conductive region and the non-conductive region, providing an etching slurry on a surface of the masking layer in the non-conductive region and removing the masking layer in the non-conductive region using the etching slurry to obtain the first patterned photovoltaic cell preform.

13. The method according to claim 6, wherein the at least removing a partial thickness of the polycrystalline silicon layer in the non-conductive region is carried out by:
at least removing a partial thickness of the polycrystalline silicon layer in the non-conductive region using an alkaline solution and an additive.
